# EUROPÄISCHE PATENTSCHRIFT

(11) **EP 3 613 072 B1**
(45) Veröffentlichungstag und Bekanntmachung des Hinweises auf die Patenterteilung: **27.07.2022**
(21) Anmeldenummer: 18719803.1
(22) Anmeldetag: 17.04.2018
(51) Int. Cl.: H01L 21/687, C30B 25/12, C23C 16/458

(54) **SUSZEPTOR ZUM HALTEN EINER HALBLEITERSCHEIBE MIT ORIENTIERUNGSKERBE SOWIE ABSCHEIDEVERFAHREN**
SUSCEPTOR FOR HOLDING A SEMICONDUCTOR WAFER WITH ORIENTATION NOTCH AND DEPOSITION METHOD
SUPPORT POUR MAINTENIR UN SUBSTRAT SEMICONDUCTEUR AVEC ENCOCHE D'ORIENTATION AINSI QUE MÉTHODE DE DÉPÔT

(30) Priorität: 20.04.2017 DE 102017206671
(43) Veröffentlichungstag der Anmeldung: 26.02.2020
(73) Patentinhaber: Siltronic AG, 81677 München (DE)
(72) Erfinder: SCHAUER, Reinhard, 83410 Laufen (DE)
(74) Vertreter: Staudacher, Wolfgang
(86) Internationale Anmeldenummer: PCT/EP2018/059726
(87) Internationale Veröffentlichungsnummer: WO 2018/192902

(56) Entgegenhaltungen:
- DE-A1-102011 007 682
- JP-A- 2013 051 290
- KR-A- 20120 112 971
- US-A1- 2009 031 954
- US-A1- 2010 029 066
- US-A1- 2012 309 175
- US-A1- 2013 263 779
- US-A1- 2015 275 395

## Beschreibung

Gegenstand der Erfindung ist ein Suszeptor zum Halten einer Halbleiterscheibe mit Orientierungskerbe während des Abscheidens einer Schicht auf einer Vorderseite der Halbleiterscheibe. Darüber hinaus ist Gegenstand der Erfindung auch ein Verfahren zum Abscheiden der Schicht auf einer Vorderseite einer Halbleiterscheibe mit Orientierungskerbe unter Verwendung des Suszeptors, wobei die Halbleiterscheibe eine <100>-Orientierung aufweist.

### Stand der Technik / Probleme

In US 2008/0118712 A1 ist ein Suszeptor beschrieben, umfassend einen Suszeptorring und einen Suszeptorboden. Der Suszeptorring hat einen Sims (ledge) zum Ablegen einer Halbleiterscheibe im Randbereich der Rückseite der Halbleiterscheibe und wird zum Abscheiden einer Schicht auf der Vorderseite der Halbleiterscheibe auf dem Suszeptorboden abgelegt. Die abgelegte Halbleiterscheibe befindet sich in einer Tasche des Suszeptors, wobei der Radius zwischen der Mitte des Suszeptorrings und dem inneren Rand der äußeren Begrenzung den Radius der Tasche definiert. Der Suszeptorring und der Suszeptorboden bilden eine zweiteilige Einheit.

DE 10 2011 007 682 A1 offenbart einen Suszeptor, der eine Ablagefläche zum Ablegen der Halbleiterscheibe im Randbereich einer Rückseite der Halbleiterscheibe aufweist sowie eine Ausbuchtung der Ablagefläche nach innen, wobei die Ausbuchtung eine Orientierungskerbe einer abgelegten Halbleiterscheibe vollständig unterlegt. Eine Suszeptor mit einer solchen Ausbuchtung ist auch in JP 2013 051290 A gezeigt.

Suszeptorring und Suszeptorboden können auch als einteiliger Suszeptor ausgebildet sein. In US 2007/0227441 A1 ist ein solcher Suszeptor beschrieben, und in dieser Druckschrift wird auf periodische Schwankungen der Dicke der epitaktischen Schicht im Randbereich von epitaktisch beschichteten Halbleiterscheiben aus Silizium hingewiesen. Grund sind unterschiedliche Wachstumsgeschwindigkeiten, mit denen die epitaktische Schicht wächst. Die unterschiedlichen Wachstumsgeschwindigkeiten stehen in Zusammenhang mit der Kristallorientierung. In einem Kantenbereich, der an die Vorderseite der Halbleiterscheibe angrenzt, sind Kristallebenen exponiert, die unterschiedliche Kristallorientierungen haben. Bei Halbleiterscheiben aus einkristallinem Silizium mit <100>-Orientierung wechseln die Kristallorientierungen periodisch entlang des Umfangs der Halbleiterscheibe. Es gibt vier Stellen im Kantenbereich im Abstand von jeweils 90° mit <110>-Orientierung, an denen eine epitaktische Schicht vergleichsweise schnell wächst und vier weitere Stellen im Abstand von jeweils 45° zu den anderen vier Stellen, an denen einen epitaktische Schicht vergleichsweise langsam wächst. Um die Dicke der epitaktischen Schicht im Randbereich zu vergleichmäßigen, wird in US 2007/0227441 A1 vorgeschlagen, die Struktur des Suszeptors mit der Periode der Dickenschwankungen zu verändern. Diese Lehre lässt unberücksichtigt, dass Halbleiterscheiben, bei denen die erwähnten Dickenschwankungen als problematisch betrachtet werden, mit einer Orientierungskerbe (notch) im Randbereich versehen sind. Bei Halbleiterscheiben aus Silizium mit <100>-Orientierung der Vorderseite befindet sich die Orientierungskerbe meistens an einer der vier Stellen, an denen eine epitaktische Schicht vergleichsweise schnell wächst und markiert eine von vier <110>-Kristallrichtungen. Gelegentlich befindet sich die Orientierungsskerbe auch 45° entfernt von einer solchen Stelle und markiert eine von vier <100>-Kristallrichtungen.

In US 2009/0031954 A1 wird vorgeschlagen, mittels baulicher Maßnahmen am Suszeptor das Kristallwachstum im Randbereich einer Halbleiterscheibe während des Abscheidens einer epitaktischen Schicht zu vereinheitlichen.

Aufgabe der vorliegenden Erfindung ist es, das Vorhandensein der Orientierungskerbe mit zu berücksichtigen und für maßgeschneiderte Wachstumsbedingungen an den erwähnten Stellen im Kantenbereich zu sorgen.

Die Aufgabe der Erfindung wird gelöst durch einen Suszeptor (1) zum Halten einer Halbleiterscheibe (2) mit Orientierungskerbe (3) während des Abscheidens einer Schicht (4) auf einer Vorderseite der Halbleiterscheibe (2), umfassend einen Suszeptorring (6) und einen Suszeptorboden (7), der Suszeptorring (6) umfassend eine Ablagefläche (8) zum Ablegen der Halbleiterscheibe (2) im Randbereich einer Rückseite der Halbleiterscheibe (2) und eine an die Ablagefläche (8) angrenzende stufenförmigen äußere Begrenzung (10) des Suszeptorrings (6), dadurch gekennzeichnet, dass der Suszeptor (1) vier Positionen aufweist, an denen sich die Struktur des Suszeptors (1) unterscheidet von der Struktur des Suszeptors (1) an weiteren vier Positionen, wobei der Abstand von einer der vier Positionen zur nächsten der vier Positionen 90° und der Abstand von einer der vier Positionen zur nächsten weiteren Position 45° beträgt, und eine der vier Positionen eine Notch-Position ist, an der sich die Struktur des Suszeptors (1) unterscheidet von der Struktur des Suszeptors an den drei anderen der vier Positionen des Suszeptors (1), wobei an der Notch-Position des Suszeptors (1) eine Ausbuchtung (13) der Ablagefläche (8) nach innen und eine Ausbuchtung (14) der äußeren Begrenzung (10) nach innen vorhanden sind.

Der Suszeptorring und der Suszeptorboden können als einteilige oder als zweiteilige Einheit ausgebildet sein. Bevorzugt ist eine zweiteilige Ausführung, wobei der Suszeptorboden vorzugsweise aus Graphit-Filz oder aus Graphit-Filz, der mit Siliziumcarbid beschichtet ist, oder aus Graphit, der mit Siliziumcarbid beschichtet ist, oder aus Siliziumcarbid besteht, und der Suszeptorring vorzugsweise aus Siliziumcarbid oder aus einem anderen Material, das mit Siliziumcarbid beschichtet ist. Bei dem anderen Material handelt es sich vorzugsweise um Graphit oder Silizium. Der Suszeptorring umfasst eine Ablagefläche (ledge) zum Ablegen einer Halbleiterscheibe im Randbereich der Rückseite der Halbleiterscheibe und eine an die Ablagefläche angrenzende stufenförmige äußere Begrenzung. Die abgelegte Halbleiterscheibe befindet sich in einer Tasche des Suszeptors.

Die Ablagefläche hat eine radiale Breite und erstreckt sich vom inneren Rand der äußeren Begrenzung nach innen. Vorzugsweise ist die Ablagefläche in einem innen liegenden Teilbereich oder vollständig nach innen abfallend geformt.

Die äußere Begrenzung hat eine radiale Breite, die dem Abstand zwischen dem inneren Rand und einem äußeren Rand der äußeren Begrenzung entspricht. Die äußere Begrenzung hat eine obere Begrenzungsfläche und am inneren Rand eine Höhe, die sich von der Ablagefläche bis zur oberen Begrenzungsfläche erstreckt. Am inneren und am äußeren Rand der äußeren Begrenzung hat der Suszeptor jeweils eine Dicke.

An vier Positionen des Suszeptors, die über den Umfang verteilt sind, ist die Struktur des Suszeptors unterschiedlich zur Struktur des Suszeptors an vier weiteren Positionen des Suszeptors, die über den Umfang verteilt sind. Die vier Positionen haben jeweils einen Abstand von 90° zur nächsten der vier Positionen und jeweils einen Abstand von 45° zu nächsten der vier weiteren Positionen. Darüber hinaus unterscheidet sich die Struktur des Suszeptors an drei der vier Positionen von der Struktur an der vierten Position, der Notch-Position.

An der Notch-Position des Suszeptors sind eine Ausbuchtung der Ablagefläche nach innen und eine Ausbuchtung der äußeren Begrenzung nach innen vorhanden. Vorzugsweise bleibt die Struktur des Suszeptors in Umfangsrichtung über eine laterale Ausdehnung von ± 22,5° von den drei der vier Positionen unverändert. Besonders bevorzugt ist es jedoch, den Suszeptor so zu gestalten, das die Strukturänderung in Umfangsrichtung in unmittelbarer Nachbarschaft der drei der vier Positionen beginnt, beispielsweise in einer Entfernung von nicht mehr als ± 1°, und rasch voranschreitet, vorzugsweise so schnell, dass die Struktur der vier weiteren Positionen bereits bei einer Entfernung von nicht mehr als ± 5° erreicht ist.

Der Suszeptor wird in einem Verfahren zum Abscheiden einer Schicht auf einer Vorderseite einer Halbleiterscheibe mit Orientierungskerbe verwendet. Die Halbleiterscheibe hat eine <100>-Orientierung, und das Verfahren umfasst das Ablegen der Halbleiterscheibe auf der Ablagefläche des Suszeptorrings derart, dass die Orientierungskerbe und die Notch-Position des Suszeptors auf einer Line angeordnet sind, die zur Mitte der Halbleiterscheibe weist; und das Beschichten der Vorderseite der Halbleiterscheibe in einem Einzelscheibenreaktor.

Die Vorderseite der Halbleiterscheibe ist die obere Hauptfläche der Halbleiterscheibe, auf der die epitaktische Schicht abgeschieden wird, beispielsweise die (100)-Fläche. Die Orientierungskerbe ist eine Einbuchtung im Kantenbereich der Halbleiterscheibe, dort wo eine <110>-Richtung von der Kante zeigt, also an einer der Stellen, an denen die epitaktische Schicht vergleichsweise schnell wächst.

Die Halbleiterscheibe besteht vorzugsweise aus Silizium, Germanium oder aus einer Mischung dieser Elemente. Es kann aber auch eine SOI-Scheibe (silicon on insulator), eine gebondete Halbleiterscheibe oder eine Substratscheibe sein, die bereits mit einer oder mehreren epitaktischen Schichten beschichtet worden ist. Die epitaktische Schicht besteht vorzugsweise aus Silizium, Germanium oder aus einer Mischung dieser Elemente, und enthält gegebenenfalls Dotierstoff.

Die Halbleiterscheibe kann von einem Einkristall abgetrennt werden, der nach der FZ-Methode (float zone) oder nach der CZ-Methode kristallisiert wurde. Die CZ-Methode umfasst das Eintauchen eines Keimkristalls in eine Schmelze, die in einem Tiegel enthalten ist, und das Anheben des Keimkristalls und des daran kristallisierenden Einkristalls von der Schmelze.

Die Halbleiterscheibe hat einen Durchmesser von mindestens 200 mm, vorzugsweise mindestens 300 mm.

Die erfindungsgemäße Anordnung der Halbleiterscheibe auf der Ablagefläche in Kombination mit der Struktur des Suszeptors stellt angepasste Bedingungen für das Wachsen der epitaktischen Schicht zur Verfügung. Drei der vier Stellen, an denen die epitaktische Schicht vergleichsweise schnell wächst, korrespondieren mit drei der vier Positionen des Suszeptors. Die vierte Stelle, die derjenigen entspricht, wo sich auch die Orientierungskerbe befindet, korrespondiert mit der vierten der vier Positionen des Suszeptors, der Notch-Position. Die Struktur des Suszeptors an der Notch-Position unterscheidet sich von der Struktur des Suszeptors an den drei der vier Positionen des Suszeptors. Gemäß einer Ausgestaltung der Erfindung entspricht die Struktur des Suszeptors an der Notch-Position der Struktur des Suszeptors an den weiteren vier Positionen des Suszeptors. Gemäß einer anderen Ausgestaltung der Erfindung ist die Struktur an der vierten Position des Suszeptors auch eine andere, als an den vier weiteren Positionen des Suszeptors.

Die bezüglich der vorstehend ausgeführten Ausführungsformen der erfindungsgemäßen Vorrichtung angegebenen Merkmale können entsprechend auf das erfindungsgemäße Verfahren übertragen werden. Diese und andere Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

### Kurzbeschreibung der Figuren

**Fig. 1** zeigt einen Suszeptor umfassend einen Suszeptorring und einen Suszeptorboden.
**Fig.2** zeigt in Draufsicht eine Halbleiterscheibe mit <100>-Orientierung.
**Fig.3** und **Fig.4** zeigen im Vertikalschnitt einen Suszeptor und eine auf der Ablagefläche des Suszeptorrings abgelegte Halbleiterscheibe.
**Fig.5** zeigt in Draufsicht einen Ausschnitt des Suszeptorrings 6 und einer auf der Ablagefläche 8 des Suszeptorrings 6 liegenden Halbleiterscheibe 2.
**Fig.6** zeigt die Seitenansicht eines Teils der Ablagefläche und des inneren Rands der äußeren Begrenzung eines Suszeptorrings.
**Fig.7** und **Fig.8** zeigen jeweils die Topographie der Rückseite von Halbleiterscheiben nach dem Abscheiden einer epitaktischen Schicht auf der Vorderseite.

### Liste der verwendeten Bezugszeichen

- **1**: Suszeptor
- **2**: Halbleiterscheibe
- **3**: Orientierungskerbe der Halbleiterscheibe
- **4**: Schicht
- **5**: äußerer Rand der Halbleiterscheibe
- **6**: Suszeptorring
- **7**: Suszeptorboden
- **8**: Ablagefläche des Suszeptorrings
- **9**: innerer Rand der Ablagefläche
- **10**: äußere Begrenzung des Suszeptorrings
- **11**: innerer Rand der äußeren Begrenzung
- **12**: äußerer Rand der äußeren Begrenzung
- **13**: Ausbuchtung der Ablagefläche
- **14**: Ausbuchtung der äußeren Begrenzung

Detaillierte Beschreibung erfindungsgemäßer Ausführungsbeispiele

Der Schutzbereich des Patents wird durch die Patentansprüche bestimmt.

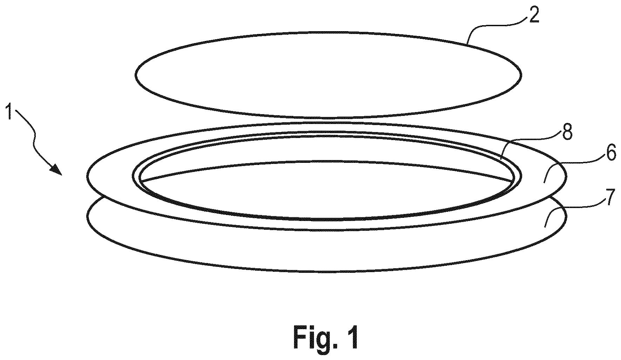

Fig.1 zeigt die relative Anordnung des Suszeptorbodens 7, des Suszeptorrings 6 und einer Halbleiterscheibe 2 mit Orientierungskerbe 3. Der Suszeptorring 6 liegt während des Gebrauchs auf dem Suszeptoboden 7 und die Halbleiterscheibe 2 auf einer Ablagefläche 8 des Suszeptorrings 6. Die Durchmesser des Suszeptorbodens 7 und des Suszeptorrings 6 können gleich sein. Der Durchmesser des Suszeptorbodens 7 kann aber auch größer sein, als der Durchmesser des Suszeptorrings 6. Der Suszeptorring 6 und der Suszeptorboden 7 können abweichend von der Darstellung auch eine einteilige Einheit bilden.

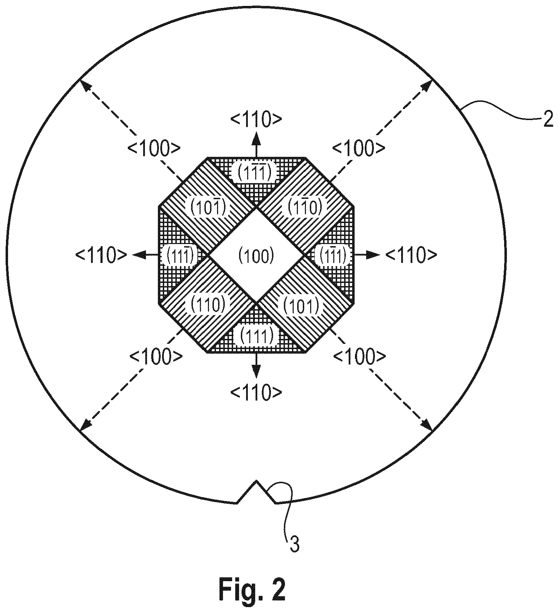

Fig.2 zeigt eine Halbleiterscheibe 2 mit einer Orientierungskerbe 3. Die Halbleiterscheibe 2 weist eine <100>-Orientierung auf. Die obere Seitenfläche der Halbleiterscheibe 2 ist beispielsweise die (100)-Ebene. Die Orientierungskerbe 3 markiert eine von vier <110>-Kristallrichtungen, die um den Umfang der Halbleiterscheibe im Abstand von 90° verteilt auf entsprechende Ebenen im Bereich der Kante der Halbleiterscheibe hinweisen, auf denen eine epitaktische Schicht mit vergleichsweise höherer Geschwindigkeit aufwächst, als auf Ebenen im Bereich der Kante, auf welche vier <100>-Kristallrichtungen hinweisen.

Korrespondierend dazu weist ein erfindungsgemäßer Suszeptor 1 vier Positionen auf, an denen sich die Struktur des Suszeptors unterscheidet von der Struktur, die der Suszeptor an vier weiteren Positionen hat. Der Abstand von einer der vier Positionen zur nächsten Position beträgt 90° und der Abstand von einer der vier Positionen zur nächsten weiteren Position beträgt 45°. Darüber hinaus unterscheidet sich die Struktur des Suszeptors an einer der vier Positionen von der Struktur, die der Suszeptor an den drei anderen Positionen aufweist. Diese eine Position wird nachfolgend Notch-Position genannt, weil während des Gebrauchs des Suszeptors vorgesehen ist, eine Halbleiterscheibe mit <100>-Orientierung derart auf der Ablagefläche des Suszeptorrings abzulegen, dass deren Orientierungskerbe 3 und die Notch-Position auf einer Linie angeordnet sind, die zur Mitte der Halbleiterscheibe weist.

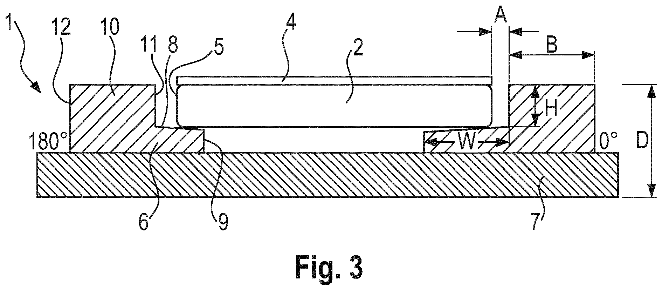

Fig.3 zeigt im Vertikalschnitt einen Suszeptor 1 und eine auf der Ablagefläche 8 des Suszeptorrings 6 abgelegte Halbleiterscheibe 2. Der Vertikalschnitt verläuft durch die mit 0° gekennzeichnete Notch-Position und durch die Position, die der Notch-Position gegenüberliegt und mit 180° gekennzeichnet ist.

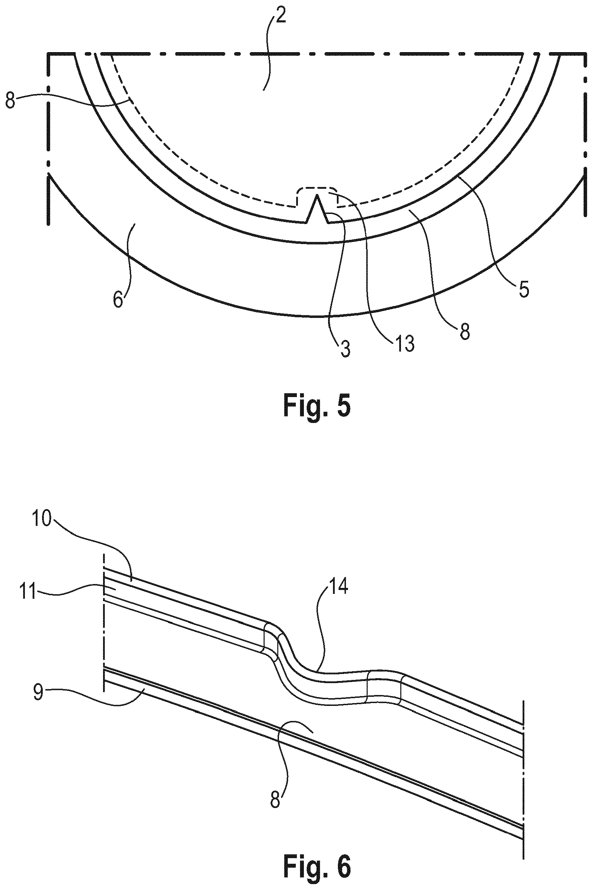

Eine erste Ausführungsform eines erfindungsgemäßen Suszeptors sieht vor, dass der Abstand A zwischen dem äußeren Rand der Halbleiterscheibe 5 und dem inneren Rand 11 der äußeren Begrenzung 10 des Suszeptorrings 6 an den drei der vier Positionen des Suszeptors 1 kleiner ist, als an der vierten Position, der Notch-Position, und kleiner ist, als an den weiteren vier Positionen des Suszeptors. An der Notch-Position hat der Suszeptor eine Struktur, die durch eine nach innen gerichtete Ausbuchtung der Ablagefläche 13 (Fig.5) und durch eine, nach innen gerichtete Ausbuchtung der äußeren Begrenzung 14 (Fig.6) gekennzeichnet ist.

Eine zweite Ausführungsform eines erfindungsgemäßen Suszeptors sieht vor, dass die radiale Breite W der Ablagefläche 8 des Suszeptorrings 6 an den drei Positionen der vier Positionen des Suszeptors 1 kleiner ist, als an der vierten Position, der Notch-Position, und kleiner ist, als an den weiteren vier Positionen des Suszeptors. An der Notch-Position hat der Suszeptor eine Struktur, die durch eine, nach innen gerichtete Ausbuchtung der Ablagefläche 13 (Fig.5) und durch eine, nach innen gerichtete Ausbuchtung der äußeren Begrenzung 14 (Fig.6) gekennzeichnet ist.

Eine dritte Ausführungsform eines erfindungsgemäßen Suszeptors sieht vor, dass die Höhe H der äußeren Begrenzung des Suszeptorrings an den drei Positionen der vier Positionen des Suszeptors 1 größer ist, als an der vierten Position, der Notch-Position, und größer ist, als an den weiteren vier Positionen des Suszeptors 1. An der Notch-Position hat der Suszeptor eine Struktur, die durch eine, nach innen gerichtete Ausbuchtung der Ablagefläche 13 (Fig.5) und durch eine, nach innen gerichtete Ausbuchtung der äußeren Begrenzung 14 (Fig.6) gekennzeichnet ist.

Eine vierte Ausführungsform eines erfindungsgemäßen Suszeptors sieht vor, dass die Dicke D des Suszeptors 1 an den drei Positionen der vier Positionen des Suszeptors 1 kleiner ist, als an der vierten Position, der Notch-Position, und kleiner, als an den weiteren vier Positionen des Suszeptors 1. An der Notch-Position hat der Suszeptor eine Struktur, die durch eine, nach innen gerichtete Ausbuchtung der Ablagefläche 13 (Fig.5) und durch eine, nach innen gerichtete Ausbuchtung der äußeren Begrenzung 14 (Fig.6) gekennzeichnet ist.

Eine fünfte Ausführungsform eines erfindungsgemäßen Suszeptors sieht vor, dass die radiale Breite B der äußeren Begrenzung des Suszeptorrings 6 an den drei Positionen der vier Positionen des Suszeptors 1 kleiner ist, als an der vierten Position, der Notch-Position, und kleiner, als an den weiteren vier Positionen des Suszeptors. An der Notch-Position hat der Suszeptor eine Struktur, die durch eine, nach innen gerichtete Ausbuchtung der Ablagefläche 13 (Fig.5) und durch eine, nach innen gerichtete Ausbuchtung der äußeren Begrenzung 14 (Fig.6) gekennzeichnet ist.

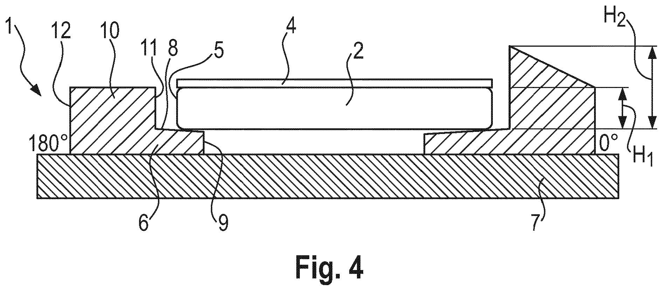

Eine sechste Ausführungsform eines erfindungsgemäßen Suszeptors sieht vor, dass die äußere Begrenzung 10 des Suszeptorrings 6 an den drei anderen der vier Positionen des Suszeptors 1 vom inneren Rand 11 der äußeren Begrenzung 6 bis zum äußeren Rand 12 der äußeren Begrenzung 6 von einer Höhe H₂ auf eine Höhe H₁ abnimmt, und an der Notch-Position des Suszeptors 1 und den weiteren vier Positionen des Suszeptors auf der Höhe H₁ bleibt (Fig.4). Die Höhe H₂ reicht vorzugsweise über die Ebene der oberen Seitenfläche einer auf der Ablagefläche des Suszeptorrings liegenden Halbleiterscheibe. An der Notch-Position hat der Suszeptor eine Struktur, die durch eine, nach innen gerichtete Ausbuchtung der Ablagefläche 13 (Fig.5) und durch eine, nach innen gerichtete Ausbuchtung der äußeren Begrenzung 14 (Fig.6) gekennzeichnet ist.

Fig.5 zeigt in Draufsicht einen Ausschnitt des Suszeptorrings 6 und einer auf der Ablagefläche 8 des Suszeptorrings 6 liegenden Halbleiterscheibe 2. Dargestellt ist der Bereich um die Notch-Position des Suszeptors. Die Orientierungskerbe 3 der Halbleiterscheibe 2 ist unterlegt durch eine Ausbuchtung 13 der Ablagefläche 8 des Suszeptorrings 6. Ohne die Ausbuchtung 13 würde die Orientierungskerbe 3 über den inneren Rand der Ablagefläche 8 hinaus nach innen ragen. In den Bereichen außerhalb der Ausbuchtung 13, also auch an den anderen drei der vier Positionen und den weiteren vier Positionen des Suszeptors 1 ist die radiale Breite W der Ablagefläche 8 kleiner als an der Notch-Position.

Fig.6 zeigt die Seitenansicht eines Teils der Ablagefläche 8 und des inneren Rands 11 der äußeren Begrenzung 10 des Suszeptorrings 6. Dargestellt ist der Bereich um die Notch-Position des Suszeptors. An dieser Position des Suszeptors 1 ist eine Ausbuchtung 14 der äußeren Begrenzung 10 nach innen vorhanden. Die Ausbuchtung 14 ist vorzugsweise so geformt, dass sie in die Orientierungskerbe 3 einer auf der Ablagefläche 8 abgelegten Halbleiterscheibe ragt.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

Daher sollen alle derartigen Abänderungen und Modifikationen sowie Äquivalente durch den Schutzbereich der Ansprüche abgedeckt sein.

Die vorstehende Beschreibung betrachtet die Situation, wenn die Orientierungskerbe eine von vier <110>-Kristallrichtungen markiert. Markiert die Orientierungskerbe eine von vier <100>-Kristallrichtungen, gilt abweichend vorzugsweise eine der nachfolgenden Bedingungen:
a) im Zustand einer auf der Ablagefläche liegenden Halbleiterscheibe ist der Abstand A, der zwischen dem äußeren Rand der Halbleiterscheibe und dem inneren Rand der äußeren Begrenzung des Suszeptorrings besteht, an den drei anderen der vier Positionen des Suszeptors größer, als an der Notch-Position des Suszeptors und größer, als an den weiteren vier Positionen des Suszeptors;
b) die radiale Breite W der Ablagefläche des Suszeptorrings ist an den drei anderen der vier Positionen des Suszeptors größer, als an der Notch-Position des Suszeptors und größer, als an den weiteren vier Positionen des Suszeptors;
c) die Höhe H der äußeren Begrenzung des Suszeptorrings an den drei anderen der vier Positionen des Suszeptors ist kleiner, als an der Notch-Position des Suszeptors und kleiner, als an den weiteren vier Positionen des Suszeptors;
d) die Dicke D des Suszeptors ist an den drei anderen der vier Positionen des Suszeptors größer, als an der Notch-Position des Suszeptors und größer, als an den weiteren vier Positionen des Suszeptors;
e) die radiale Breite B der äußeren Begrenzung des Suszeptorrings ist an den drei anderen der vier Positionen des Suszeptors größer, als an der Notch-Position des Suszeptors und größer, als an den weiteren vier Positionen des Suszeptors; und
f) die äußere Begrenzung des Suszeptorrings bleibt an den drei anderen der vier Positionen des Suszeptors vom inneren Rand der äußeren Begrenzung bis zum äußeren Rand der äußeren Begrenzung auf der Höhe H₁, und nimmt an der Notch-Position des Suszeptors und den weiteren vier Positionen des Suszeptors von der Höhe H₂ auf die Höhe H₁ ab.

### Beispiel:

Halbleiterscheiben aus einkristallinem Silizium mit <100>-Orientierung und einem Durchmesser von 300 mm wurden in einem Einzelscheibenreaktor mit einer epitaktischen Schicht aus Silizium beschichtet. Die Dicke der epitaktischen Schicht betrug 2 µm. Der Suszeptor war gemäß der sechsten Ausführungsform ausgebildet. Die Halbleiterscheiben wiesen eine eine <110>-Richtung markierende Orientierungskerbe auf und wurden derart auf den Suszeptor gelegt, dass die Orientierungskerbe und die Notch-Position des Suszeptors auf einer Linie angeordnet waren, die zur Mitte der Halbleiterscheibe wies. Darüber hinaus waren am Suszeptor an der Notch Position sowohl eine Ausbuchtung der Ablagefläche nach innen als auch eine Ausbuchtung der äußeren Begrenzung nach innen vorhanden.

Mit dieser Konfiguration des Suszeptors konnte eine Ebenheit im Randbereich erzielt werden, ausgedrückt als ESFQRmax und einem Randusschluss von 1 mm, von nicht mehr als 150 nm. Insbesondere konnte damit auch das Entstehen einer Aufwachsung auf der Rückseite der Halbleiterscheibe im Bereich der Orientierungskerbe, eines sogenannten "notch-bump", unterdrückt werden.

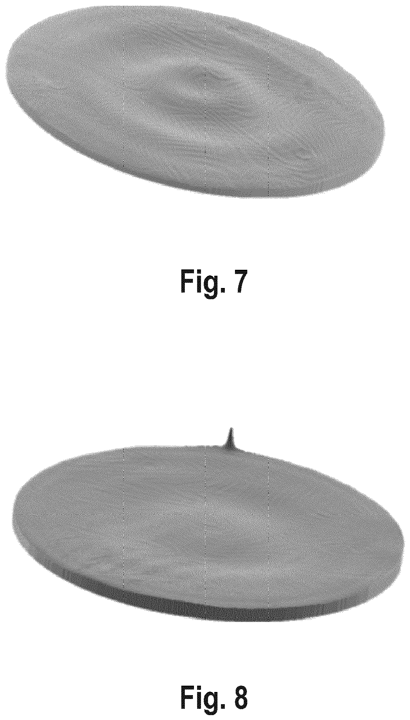

Fig.7 zeigt die Topographie der Rückseite einer solchen Halbleiterscheibe und Fig.8 zum Vergleich diejenige einer Halbleiterscheibe mit "notch bump", der nicht unterdrückt werden konnte, weil dem Suszeptor an der Notch-Position die Ausbuchtungen fehlten.

## Patentansprüche

1. Suszeptor (1) zum Halten einer Halbleiterscheibe (2) mit Orientierungskerbe (3) während des Abscheidens einer Schicht (4) auf einer Vorderseite der Halbleiterscheibe (2), umfassend einen Suszeptorring (6) und einen Suszeptorboden (7), der Suszeptorring (6) umfassend eine Ablagefläche (8) zum Ablegen der Halbleiterscheibe (2) im Randbereich einer Rückseite der Halbleiterscheibe (2) und eine an die Ablagefläche (8) angrenzende stufenförmigen äußere Begrenzung (10) des Suszeptorrings (6), **dadurch gekennzeichnet,**
**dass** der Suszeptor (1) vier Positionen aufweist, an denen sich die Struktur des Suszeptors (1) unterscheidet von der Struktur des Suszeptors (1) an weiteren vier Positionen, wobei der Abstand von einer der vier Positionen zur nächsten der vier Positionen 90° und der Abstand von einer der vier Positionen zur nächsten weiteren Position 45° beträgt, und eine der vier Positionen eine Notch-Position ist, an der sich die Struktur des Suszeptors (1) unterscheidet von der Struktur des Suszeptors (1) an den drei anderen der vier Positionen des Suszeptors (1), wobei an der Notch-Position des Suszeptors (1) eine Ausbuchtung (13) der Ablagefläche (8) nach innen und eine Ausbuchtung (14) der äußeren Begrenzung (10) nach innen vorhanden sind.

2. Suszeptor nach Anspruch 1, **dadurch gekennzeichnet, dass**, im Zustand einer auf der Ablagefläche (8) liegenden Halbleiterscheibe (2), ein Abstand A, der zwischen einem äußeren Rand (5) der Halbleiterscheibe (2) und einem inneren Rand (11) der äußeren Begrenzung (10) des Suszeptorrings (6) besteht, an den drei anderen der vier Positionen des Suszeptors (1) kleiner ist, als an der Notch-Position des Suszeptors (1) und kleiner, als an den weiteren vier Positionen des Suszeptors (1).

3. Suszeptor (1) nach Anspruch 1, **dadurch gekennzeichnet, dass** eine radiale Breite W der Ablagefläche (8) des Suszeptorrings (6) an den drei anderen der vier Positionen des Suszeptors (1) kleiner ist, als an der Notch-Position des Suszeptors (1) und kleiner, als an den weiteren vier Positionen des Suszeptors (1).

4. Suszeptor (1) nach Anspruch 1, **dadurch gekennzeichnet, dass** eine Höhe H der äußeren Begrenzung (10) des Suszeptorrings (6) an den drei anderen der vier Positionen des Suszeptors (1) größer ist, als an der Notch-Position des Suszeptors (1) und größer, als an den weiteren vier Positionen des Suszeptors (1).

5. Suszeptor (1) nach Anspruch 1, **dadurch gekennzeichnet, dass** eine Dicke D des Suszeptors (1) an den drei anderen der vier Positionen des Suszeptors (1) kleiner ist, als an der Notch-Position des Suszeptors (1) und kleiner, als an den weiteren vier Positionen des Suszeptors (1).

6. Suszeptor (1) nach Anspruch 1, **dadurch gekennzeichnet, dass** eine radiale Breite B der äußeren Begrenzung (10) des Suszeptorrings (6) an den drei anderen der vier Positionen des Suszeptors (1) kleiner ist, als an der Notch-Position des Suszeptors (1) und kleiner, als an den weiteren vier Positionen des Suszeptors (1).

7. Suszeptor (1) nach Anspruch 1, **dadurch gekennzeichnet, dass** die äußere Begrenzung (10) des Suszeptorrings (6) an den drei anderen der vier Positionen des Suszeptors (1) vom inneren Rand (11) der äußeren Begrenzung (10) bis zum äußeren Rand (12) der äußeren Begrenzung (10) von einer Höhe H₂ auf eine Höhe H₁ abnimmt, an der Notch-Position des Suszeptors (1) und den weiteren vier Positionen des Suszeptors (1) auf der Höhe H₁ bleibt.

8. Verfahren zum Abscheiden einer Schicht (4) auf einer Vorderseite einer Halbleiterscheibe (2) mit Orientierungskerbe (3), wobei die Halbleiterscheibe (2) eine <100>-Orientierung aufweist, umfassend
das Ablegen der Halbleiterscheibe (2) auf einem Suszeptorring (6) nach einem der Ansprüche 1 bis 7 derart, dass die Orientierungskerbe (3) und die Notch-Position des Suszeptors (1) auf einer Line angeordnet sind, die zur Mitte der Halbleiterscheibe (2) weist; und das Beschichten der Vorderseite der Halbleiterscheibe (2) in einem Einzelscheibenreaktor.

## Claims

1. A susceptor (1) for holding a semiconductor wafer (2) having an orientation notch (3) while depositing a layer (4) on a front side of the semiconductor wafer (2), comprising a susceptor ring (6) and a susceptor bottom (7), the susceptor ring (6) comprising a depositing surface (8) for depositing the semiconductor wafer (2) in the edge region of a rear side of the semiconductor wafer (2), and a step-shaped outer boundary (10) of the susceptor ring (6) adjoining the depositing surface (8), **characterised in that**
**in that** the susceptor (1) has four positions at which the structure of the susceptor (1) differs from the structure of the susceptor (1) at a further four positions, the distance from one of the four positions to the next of the four positions being 90° and the distance from one of the four positions to the next further position being 45°, and one of the four positions is a notch position at which the structure of the susceptor (1) differs from the structure of the susceptor (1) at the other three of the four positions of the susceptor (1), wherein at the notch position of the susceptor (1) there is an inward bulge (13) of the deposit surface (8) and an inward bulge (14) of the outer boundary (10).

2. susceptor according to claim 1, **characterized in that**, in the state of a semiconductor wafer (2) lying on the deposition surface (8), a distance A existing between an outer edge (5) of the semiconductor wafer (2) and an inner edge (11) of the outer boundary (10) of the susceptor ring (6) is smaller at the other three of the four positions of the susceptor (1) than at the notch position of the susceptor (1) and smaller than at the other four positions of the susceptor (1).

3. susceptor (1) according to claim 1, **characterized in that** a radial width W of the deposit surface (8) of the susceptor ring (6) is smaller at the other three of the four positions of the susceptor (1) than at the notch position of the susceptor (1) and smaller than at the other four positions of the susceptor (1).

4. susceptor (1) according to claim 1, **characterized in that** a height H of the outer boundary (10) of the susceptor ring (6) is greater at the other three of the four positions of the susceptor (1) than at the notch position of the susceptor (1) and greater than at the other four positions of the susceptor (1).

5. susceptor (1) according to claim 1, **characterized in that** a thickness D of the susceptor (1) at the other three of the four positions of the susceptor (1) is smaller than at the notch position of the susceptor (1) and smaller than at the other four positions of the susceptor (1).

6. susceptor (1) according to claim 1, **characterized in that** a radial width B of the outer boundary (10) of the susceptor ring (6) is smaller at the other three of the four positions of the susceptor (1) than at the notch position of the susceptor (1) and smaller than at the other four positions of the susceptor (1).

7. susceptor (1) according to claim 1, **characterized in that** the outer boundary (10) of the susceptor ring (6) decreases from a height H₂ to a height H₁ at the other three of the four positions of the susceptor (1) from the inner edge (11) of the outer boundary (10) to the outer edge (12) of the outer boundary (10), remains at the height H₁ at the notch position of the susceptor (1) and the other four positions of the susceptor (1).

8. a method of depositing a layer (4) on a front surface of a semiconductor wafer (2) having an orientation notch (3), the semiconductor wafer (2) having a <100> orientation, comprising
depositing the semiconductor wafer (2) on a susceptor ring (6) according to any one of claims 1 to 7 such that the orientation notch (3) and the notch position of the susceptor (1) are arranged on a line facing the center of the semiconductor wafer (2); and coating the front side of the semiconductor wafer (2) in a single wafer reactor.

## Revendications

1. Suscepteur (1) pour maintenir une plaquette semi-conductrice (2) avec une encoche d'orientation (3) pendant le dépôt d'une couche (4) sur une face avant de la plaquette semi-conductrice (2), comprenant un anneau de suscepteur (6) et un fond de suscepteur (7), l'anneau de suscepteur (6) comprend une surface de dépôt (8) pour déposer la plaquette semi-conductrice (2) dans la zone de bord d'une face arrière de la plaquette semi-conductrice (2) et une délimitation extérieure (10) en forme de gradin de l'anneau de suscepteur (6), adjacente à la surface de dépôt (8), **caractérisé en ce que**
**en ce que** le suscepteur (1) présente quatre positions dans lesquelles la structure du suscepteur (1) se distingue de la structure du suscepteur (1) dans quatre autres positions, la distance de l'une des quatre positions à la suivante des quatre positions étant de 90° et la distance de l'une des quatre positions à l'autre position supplémentaire suivante étant de 45°, et l'une des quatre positions est une position d'encoche dans laquelle la structure du suscepteur (1) diffère de la structure du suscepteur (1) dans les trois autres des quatre positions du suscepteur (1), un renflement (13) de la surface de dépôt (8) vers l'intérieur et un renflement (14) de la limite extérieure (10) vers l'intérieur étant présents dans la position d'encoche du suscepteur (1).

2. Suscepteur selon la revendication 1, **caractérisé en ce que**, dans l'état d'une plaquette semi-conductrice (2) reposant sur la surface de dépôt (8), une distance A, qui existe entre un bord extérieur (5) de la plaquette semi-conductrice (2) et un bord intérieur (11) de la limite extérieure (10) de l'anneau de suscepteur (6), est plus petite dans les trois autres des quatre positions du suscepteur (1) que dans la position de Notch du suscepteur (1) et plus petite que dans les quatre autres positions du suscepteur (1).

3. Suscepteur (1) selon la revendication 1, **caractérisé en ce qu'**une largeur radiale W de la surface de dépôt (8) de l'anneau de suscepteur (6) est plus petite aux trois autres des quatre positions du suscepteur (1) qu'à la position d'encoche du suscepteur (1) et plus petite qu'aux quatre autres positions du suscepteur (1).

4. Suscepteur (1) selon la revendication 1, **caractérisé en ce qu'**une hauteur H de la limite extérieure (10) de l'anneau de suscepteur (6) est plus grande aux trois autres des quatre positions du suscepteur (1) qu'à la position de notch du suscepteur (1) et plus grande qu'aux quatre autres positions du suscepteur (1).

5. Suscepteur (1) selon la revendication 1, **caractérisé en ce qu'**une épaisseur D du suscepteur (1) aux trois autres des quatre positions du suscepteur (1) est inférieure à celle à la position d'encoche du suscepteur (1) et inférieure à celle aux quatre autres positions du suscepteur (1).

6. Suscepteur (1) selon la revendication 1, **caractérisé en ce qu'**une largeur radiale B de la limite extérieure (10) de l'anneau de suscepteur (6) est plus petite aux trois autres des quatre positions du suscepteur (1) qu'à la position de notch du suscepteur (1) et plus petite qu'aux quatre autres positions du suscepteur (1).

7. Suscepteur (1) selon la revendication 1, **caractérisé en ce que** la limite extérieure (10) de l'anneau de suscepteur (6) diminue d'une hauteur H₂ à une hauteur H₁ dans les trois autres des quatre positions du suscepteur (1), depuis le bord intérieur (11) de la limite extérieure (10) jusqu'au bord extérieur (12) de la limite extérieure (10), et reste à la hauteur H₁ dans la position d'encoche du suscepteur (1) et dans les quatre autres positions du suscepteur (1).

8. procédé pour déposer une couche (4) sur une face avant d'une plaquette semi-conductrice (2) avec une encoche d'orientation (3), la plaquette semi-conductrice (2) présentant une orientation <100>, comprenant
le dépôt de la plaquette semi-conductrice (2) sur un anneau de suscepteur (6) selon l'une quelconque des revendications 1 à 7, de telle sorte que l'encoche d'orientation (3) et la position d'encoche du suscepteur (1) soient disposées sur une ligne qui fait face au centre de la plaquette semi-conductrice (2) ; et le revêtement de la face avant de la plaquette semi-conductrice (2) dans un réacteur à plaquette unique.
